# EUROPEAN PATENT SPECIFICATION

(11) **EP 0 452 939 B1**
(45) Date of publication and mention of the grant of the patent: **02.11.2000**
(21) Application number: 91106247.9
(22) Date of filing: 18.04.1991
(51) Int. Cl.: H01L 21/00

(54) **Apparatus and method for loading workpieces in a processing system**
Vorrichtung und Methode zum Laden von Werkstücken in einem Verarbeitungssystem
Appareil et méthode pour charger des pièces dans un système de traitement

(30) Priority: 19.04.1990 US 511481
(43) Date of publication of application: 23.10.1991
(73) Proprietor: APPLIED MATERIALS, INC., Santa Clara, California 95054-3299 (US)
(72) Inventor: Toshima, Masato M., Sunnyvale, CA 94087 (US); Salzman, Phil M., San Jose, CA 95125 (US); Murdoch, Steven C., Palo Alto, CA 94306 (US); Wang, Cheng, San Jose, CA 95133 (US); Stenholm, Mark A., San Jose, CA 95133 (US); Howard, James, San Jose, CA 95132 (US); Hall, Leonard, San Jose, CA 95132 (US)
(74) Representative: Zimmermann & Partner

(56) References cited:
- EP-A- 0 343 530
- US-A- 4 640 223
- US-A- 4 715 921
- US-A- 4 891 488

## Description

The invention refers to an apparatus and a method for loading wafers in a semiconductor processing system.

Semiconductor processing equipment often has a plurality of chambers in which processing occurs. Arm assemblies or other robotic devices are generally used to move workpieces, generally wafers from a wafer queuing station to various chambers for processing. When the processing is finished the wafer is returned to the queuing station. For an example of prior art processing equipment, see U.S. Patent Number 4,715,921 issued to Maher et al. for a Quad Processor. In the art, document EP-A-0 343 530 discloses a vacuum installation for treating disc-type workpieces having a transfer chamber with a door to the atmosphere in which a wafer cassette is supported by a holder. In the transfer chamber the cassette is positioned vertically with the wafers in a horizontal position. If the wafer cassette is transported in a horizontal position outside the apparatus, an operator will tilt the cassette from a horizontal position to a vertical position when introducing the cassette and from a vertical position to a horizontal position when removing the cassette.

Semiconductor processing is typically done in a vacuum. Therefore, a wafer queuing station into which is placed a cassette of wafers to be processed must be pumped down before the wafers may be accessed. This significantly increases the time the semiconductor processing equipment is idle while waiting for a cassette of processed wafers to be exchanged for a cassette of unprocessed wafers and subsequent pumping down of the wafer queuing station.

The invention intends to overcome this and similar problems by providing a semiconductor processing system according to independent claim 1 and a method according to independent claim 4. Further advantageous features and aspects of the invention are evident from the dependent claims, the description and the drawings.

The invention provides in one aspect a semiconductor processing system having at least one processing chamber and at least one load lock which at least one load lock comprises
a chamber to receive wafers held in cassette and to forward said wafers to said at least one processing chamber
an opening in a vertical sidewall of said chamber
a door to cover and seal said opening
   wherein that said load lock further comprises
a mechanical cassette lowering means having a support structure to move said cassette with said wafers on said support structure through said opening in a drawbridge motion such that said cassette is positioned with the wafers stacked therein and with the main surfaces of said wafers in a horizontal position when said cassette with said wafers is within said chamber, and said cassette is positioned with said wafers therein with said main surfaces in a vertical position when said cassette with said wafers is outside of said chamber.

In a preferred embodiment of the invention, the load lock further comprises

a door mechanism means to open said door such that said door first moves slightly away from said opening and then moves down parallel to said vertical sidewall of said processing chamber.

Advantageously, said at least one said load lock further comprises
a pivot means to pivot said cassette with said wafers between a first position in which said cassette with said wafers may be lowered by said mechanical cassette lowering means and a second position from which said wafers from said cassette may be accessed by robotic equipment and transported for processing into said at least one processing chamber.

The invention further provides a method of loading a cassette with wafers into a semiconductor processing system as described above which method comprises the consecutive steps of:
a) moving the cassette with the wafers on the support structure through the opening in a drawbridge motion into the chamber such that the cassette with the wafers therein is positioned with their main surfaces in a vertical position when the cassette with the wafers is outside of the chamber, and the cassette is positioned with the wafers stacked therein and with the main surfaces of the wafers in a horizontal position when the cassette with the wafers is within the chamber;
b) closing the door to cover and seal the opening;
c) pumping down the chamber to create a vacuum in the chamber; and
d) processing the wafers in the at least one processing chamber.

Preferably step b) further comprises:
- moving the door upwards and parallel to the vertical sidewall of the chamber; and then
- moving the door tight against the vertical sidewall of the chamber to seal the opening.

In accordance with a preferred embodiment of the present invention, a wafer loading interface is presented for inclusion within a processing system. The wafer loading interface includes two separate chambers. Each chamber may be separately pumped down. Thus, while a first cassette of wafers, from a first chamber are being accessed, a second cassette of wafers may be loaded in the second chamber and the second chamber may then be pumped down. This can significantly increase throughput of wafers through the processing system.

In a preferred embodiment, each chamber is designed to minimize intrusion to a clean room. Thus a door to each chamber has a mechanism which, when opening the door, first moves the door slightly away from an opening in the chamber and then the door is moved down parallel to the chamber. After the door is opened, a cassette of wafers is lowered through the opening in a motion much like a drawbridge. The cassette of wafers is on a support with no side panels, facilitating the replacement of a cassette of processed wafers with a cassette of unprocessed wafers by an automated device. The cassette may be pivoted within the chamber when the position from which wafers are accessed from the cassette differs from the position from which the cassette is lowered out of the chamber.
Figure 1 shows a top view of a block diagram of semiconductor processing equipment which includes two cassette load locks in accordance with the preferred embodiment of the present invention.
Figure 2 shows a block diagram of a load lock which is part of the semiconductor processing equipment shown in Figure 1 in accordance with the preferred embodiment of the present invention.
Figure 3 shows a second block diagram of the load lock shown in Figure 2 in accordance with the preferred embodiment of the present invention.
Figure 4 shows another block diagram of the load lock shown in Figure 2 in accordance with the preferred embodiment of the present invention.
Figure 5 is a block diagram of a cassette wafer holder in a position extended out of the load lock shown in Figure 2 in accordance with the preferred embodiment of the present invention.
Figure 6 is a block diagram of the cassette wafer holder shown in Figure 5 in an upright position within the load lock shown in Figure 2 in accordance with the preferred embodiment of the present invention.

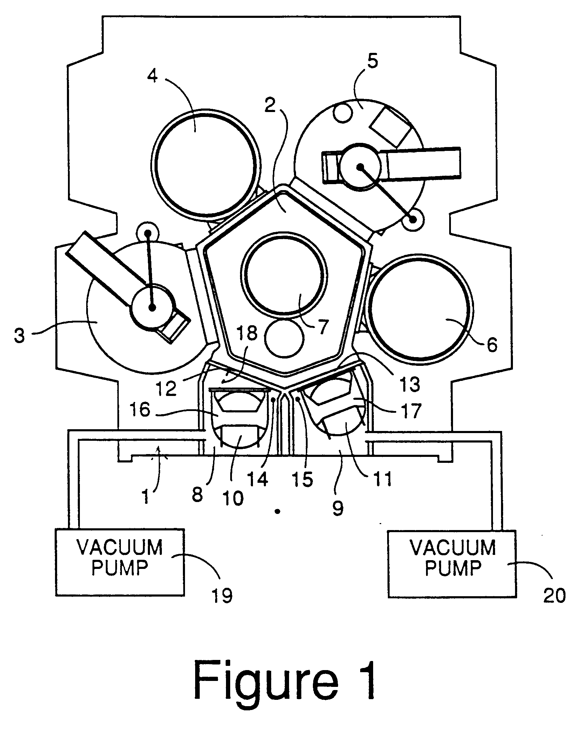

In Figure 1, a top view of semiconductor processing equipment 1 is shown. Semiconductor processing equipment 1 may be used, for example, for etching wafers.

Semiconductor processing equipment 1, includes, for example, a processing chamber 3, a processing chamber 4, a processing chamber 5 and a processing chamber 6. A central chamber 2 may be used to temporarily store wafers on robotic equipment 7 when wafers are being moved to or from various of the processing chambers.

Semiconductor processing equipment 1 also includes dual cassette load locks. In chamber 8, a wafer cassette or tray 16 holds wafers 10. In chamber 9, a wafer cassette or tray 17 holds wafers 11. Wafer tray 17 pivots around a pivot point 15. When wafers 11 from tray 17 are accessed by semiconductor processing equipment 1 for processing, wafer tray 17 is flush against a gate 13, as shown, and easily accessed by robotic equipment 7 for transportation into central chamber 2. When wafer tray 17 is ready to be removed from chamber 9, wafer tray 17 is pivoted back from gate 13 in preparation for the opening of chamber 9 and removal of wafer tray 17.

Similarly, wafer tray 16 pivots around a pivot point 14. When wafers 10 from tray 16 are accessed by semiconductor processing equipment 1 for processing, wafer tray 16 is flush against a gate 12 and easily accessed by robotic equipment 7 for transportation into central chamber 2. When wafer tray 16 is ready to be removed from chamber 8, wafer tray 16 may be pivoted back an angle 18 from gate 12, as shown, in preparation for the opening of chamber 8 and removal of wafer tray 16. In the preferred embodiment, angle 18 is about twenty-one degrees.

Chamber 8 and chamber 9 may be separately and individually pumped down. A vacuum pump 19 is able to provide a vacuum in chamber 8. A vacuum pump 20 is able to provide a vacuum in chamber 9. In Figure 1, vacuum pumps 19 and 20 are shown in schematic form. Typically pumps 19 and 20 would reside within semiconductor processing equipment 1. Further, while Figure 1 shows two separate pumps, a single pump could be used to separately and individually pump down chamber 8 and chamber 9.

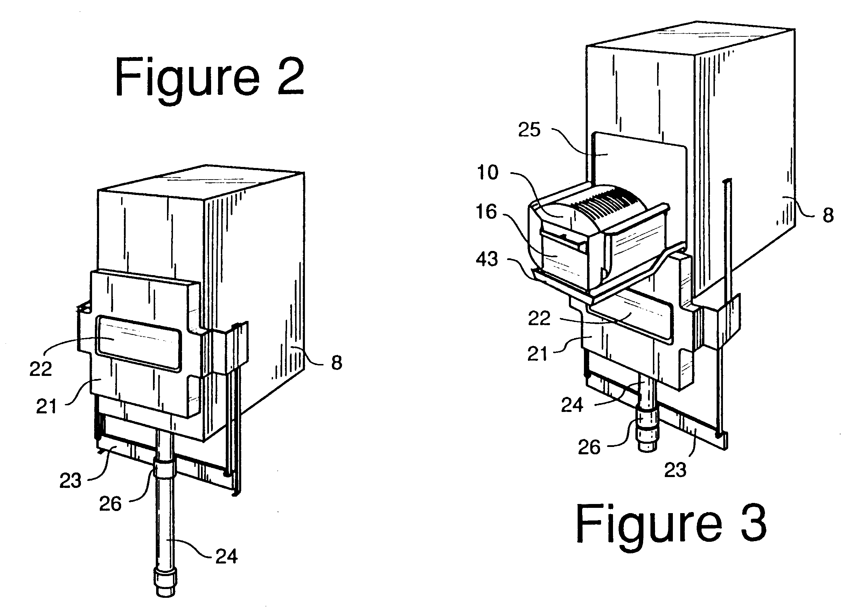

Figure 2 shows a simplified block diagram front view of wafer chamber 8. In the preferred embodiment, the volume of chamber 8 is 46 liters. A door 21 is shown in a closed position. Door 21 includes an observation window 22. Door 21 is opened and closed using a pneumatic actuator within a rod 24. Magnets in the pneumatic actuator interface attract an outer ring 26. Outer ring 26 is connected to door 21 through an assembly 23.

Figure 3 shows door 21 lowered into an open position. An opening 25, for example may be fifteen inches high and ten and one half inches* wide. By opening down, the intrusion of door 21 into a clean room may be minimized. In the preferred embodiment the total intrusion is about one inch.
* 1 inch = 2.54 cm

Once door 21 is lowered, wafer tray 16, on a support structure 43, may then be lowered out of chamber 8, much like a draw bridge is lowered at a castle entrance. Wafer tray 16 may then be removed and a new wafer tray placed upon support structure 43. Support structure 43 is designed with a hollow bottom so that when door 21 is opened and wafer tray 16 is lowered, a laminar airflow may sweep downward through wafers 10.

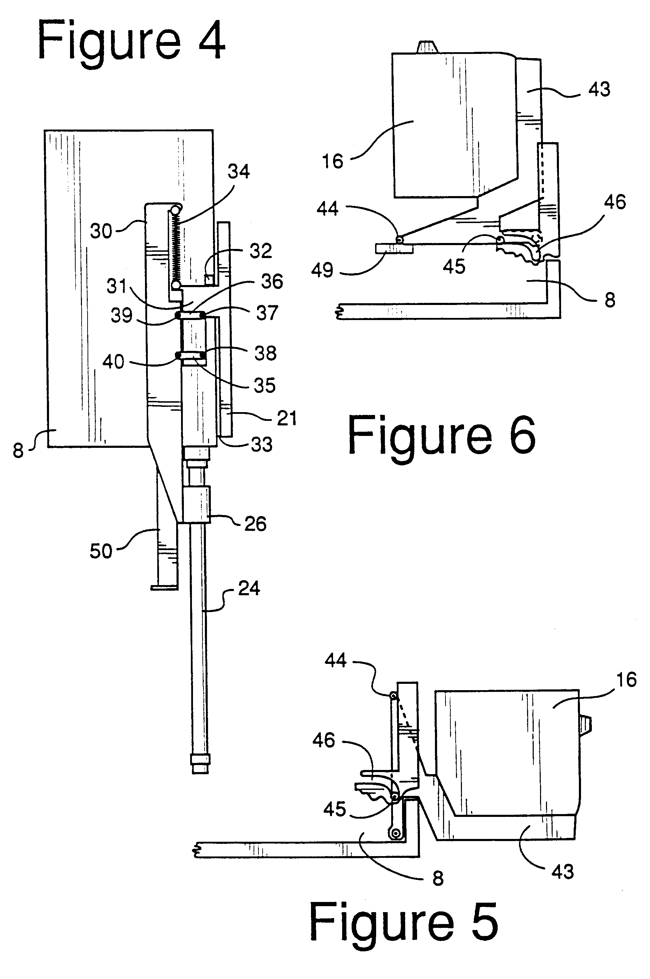

In Figure 4, additional detail of the mechanism which controls the opening and shutting door 21 is shown. A side panel 31 of door 21 is connected to a carriage 30 by a spring 34, a link 36 and a link 35. As controlled by the pneumatic actuator within rod 24, door 21 travels up and down parallel to a rail 50. When being closed, door 21 is stopped by an abutment 32; however, carriage 30 continues upward, expanding spring 34, until a gap 33 is completely closed. While carriage 30 continues moving upward, a pivot 39 connected to link 36, and a pivot 40 connected to link 35 continue moving upward. However a pivot 37 connected to link 36 and a pivot 38 connected to link 35 cause door 21 to move towards carriage 30. Therefore, as gap 33 is closed, links 35 and 36 translate the upward motion of carriage 30 into horizontal motion of door 21. Door 21 is thus brought snug against, and hence seals chamber 8.

When door 21 is opened, spring 34 compresses causing gap 33 to reappear and links 35 and 36 to straighten, thus moving door 21 horizontally away from chamber 8.

Figures 5 and 6 show a block diagram of one possible implementation of an assembly for guiding the lowering and raising of support structure 43. In Figure 5, support structure 43 and cassette 16 are shown lowered out of chamber 8. A roller 44 connected to support structure 43 is shown resting on an extension of a cam containing slot 46 within chamber 8. A roller 45, also connected to support structure 43, is shown at a first end of a slot track 46.

In Figure 6, support structure 43 and cassette 16 are shown in the upright position within chamber 8. In this position, wafers 10 are horizontal and are stacked so that they are ready to be accessed by semiconductor processing equipment 1. When support structure 43 and cassette 16 are in the upright position, roller 45 is rolled to a second end of slot track 46 and roller 44 rests against a stop 49. Stop 49 is an extension of the cam which contains slot 46.

## Claims

1. A semiconductor processing system (1) having at least one processing chamber (2-6) and at least one load lock which at least one load lock comprises:
- a chamber (8,9) to receive wafers (10,11) held in cassette (16,17) and to forward said wafers to said at least one processing chamber;
- an opening (25) in a vertical sidewall of said chamber;
- a door to cover and seal said opening;
charaterized in that said load lock further comprises
a mechanical cassette lowering means (43-49) having a support structure (43) to move said cassette with said wafers on said support structure through said opening in a drawbridge motion such that said cassette is positioned with the wafers stacked therein and with the main surfaces of said wafers in a horizontal position when said cassette with said wafers is within said chamber, and said cassette is positioned with said wafers therein with said main surfaces in a vertical position when said cassette with said wafers is outside of said chamber.

2. A semiconductor processing system according to claim 1 wherein said at least one said load lock further comprises:
a door mechanism means (30-40,50) to open said door such that said door first moves slightly away from said opening and then moves down parallel to said vertical sidewall of said processing chamber.

3. A semiconductor processing system according to claim 1 or 2 wherein said at least one said load lock further comprises:
a pivot means (14,15) to pivot said cassette with said wafers between a first position in which said cassette with said wafers may be lowered by said mechanical cassette lowering means and a second position from which said wafers from said cassette may be accessed by robotic equipment (7) and transported for processing into said at least one processing chamber.

4. A method of loading a cassette with wafers into the semiconductor processing system defined in any of claims 1-3, which method comprises the consecutive steps of:
a) moving said cassette with said wafers on said support structure through said opening in a drawbridge motion into said chamber such that said cassette with said wafers therein is positioned with their main surfaces in a vertical position when said cassette with said wafers is outside of said chamber, and said cassette is positioned with the wafers stacked therein and with the main surfaces of said wafers in a horizontal position when said cassette with said wafers is within said chamber;
b) closing said door to cover and seal said opening;
c) pumping down said chamber to create a vacuum in said chamber; and
d) processing said wafers in the at least one processing chamber.

5. A method according to claim 4 wherein step b) further comprises:
- moving said door upwards and parallel to said vertical sidewall of said chamber; and then
- moving said door tight against said vertical sidewall of said chamber to seal said opening.

## Patentansprüche

1. Halbleiterbearbeitungssystem (1) mit mindestens einer Bearbeitungskammer (2-6) und mindestens einer Schleuse, wobei die mindestens eine Schleuse folgendes umfaßt:
- eine Kammer (8, 9) zur Aufnahme von in einer Kassette (16, 17) gehaltenen Wafern (10, 11) und zur Beförderung der Wafer zu der mindestens einen Bearbeitungskammer;
- eine Öffnung (25) in einer vertikalen Seitenwand der Kammer;
- eine Tür zur Abdeckung und Abdichtung der Öffnung;
dadurch gekennzeichnet, daß die Schleuse des weiteren folgendes umfaßt:
ein mechanisches Kassettensenkmittel (43-49) mit einer Stützstruktur (43) zur Bewegung der Kassette mit den Wafern auf der Stützstruktur durch die Öffnung in einer Zugbrückenbewegung, so daß die Kassette mit den darin gestapelten Wafern und mit den Hauptflächen der Wafer in einer horizontalen Position positioniert ist, wenn sich die Kassette mit den Wafern innerhalb der Kammer befindet, und die Kassette mit den Wafern darin mit den Hauptflächen in einer vertikalen Position positioniert ist, wenn sich die Kassette mit den Wafern außerhalb der Kammer befindet.

2. Halbleiterbearbeitungssystem gemäß Anspruch 1, wobei die mindestens eine Schleuse des weiteren folgendes umfaßt:
ein Türmechanismusmittel (30-40,50) zum Öffnen der Tür, so daß die Tür sich zuerst etwas von der Öffnung wegbewegt, und sich dann nach unten parallel zur vertikalen Seitenwand der Kammer bewegt.

3. Halbleiterbearbeitungssystem gemäß Anspruch 1 oder 2, wobei die mindestens eine Schleuse des weiteren folgendes umfaßt:
ein Schwenkmittel (14, 15) zum Schwenken der Kassette mit den Wafern zwischen einer ersten Position, in welcher die Kassette mit den Wafern durch das mechanische Kassettensenkmittel senkbar ist, und einer zweiten Position, aus welcher die Wafer aus der Kassette für eine Robotervorrichtung (7) erreichbar sind und zur Bearbeitung in die mindestens eine Bearbeitungskammer transportierbar sind.

4. Verfahren zum Laden einer Kassette mit Wafern in das Halbleiterbearbeitungssystem gemäß einem der Ansprüche 1-3, wobei das Verfahren folgende aufeinanderfolgende Schritte aufweist:
a) Bewegung der Kassette mit den Wafern auf der Stützstruktur durch die Öffnung in einer Zugbrückenbewegung in die Kammer, so daß die Kassette mit den Wafern darin mit den Hauptflächen in einer vertikalen Position positioniert wird, wenn sich die Kassette mit den Wafern außerhalb der Kammer befindet, und die Kassette mit den darin gestapelten Wafern und mit den Hauptflächen der Wafer in einer horizontalen Position positioniert wird, wenn sich die Kassette mit den Wafern innerhalb der Kammer befindet;
b) Schließen der Tür zur Abdeckung und Abdichtung der Öffnung;
c) Auspumpen der Kammer, um in der Kammer ein Vakuum zu erzeugen; und
d) Bearbeitung der Wafer in der mindestens einen Bearbeitungskammer.

5. Verfahren gemäß Anspruch 4, wobei Schritt b) des weiteren folgendes umfaßt:
- Bewegung der Tür aufwärts und parallel zur vertikalen Seitenwand der Kammer; und dann
- Bewegung der Tür dicht gegen die vertikale Seitenwand der Kammer zur Abdichtung der Öffnung.

## Revendications

1. Système de traitement de semi-conducteurs (1) ayant au moins une chambre de traitement (2-6) et au moins un sas de chargement, lequel au moins un sas de chargement comprend :
- une chambre (8,9) pour recevoir des plaquettes (10,11) placées dans une cassette (16,17) et pour envoyer lesdites plaquettes vers ladite au moins une chambre de traitement ;
- une ouverture (25) ménagée dans une paroi latérale verticale de ladite chambre ;
- une porte pour couvrir hermétiquement ladite ouverture ;
caractérisé en ce que ledit sas de chargement comprend en outre
un moyen d'abaissement mécanique (43-49) de cassette ayant une structure support (43) pour déplacer ladite cassette avec lesdites plaquettes sur ladite structure support au travers de ladite ouverture selon un mouvement de pont-levis tel que ladite cassette, avec les plaquettes qui y sont empilées, est positionnée de sorte que les surfaces principales desdites plaquettes sont en position horizontale lorsque ladite cassette, avec lesdites plaquettes, est dans la chambre, et ladite cassette, avec les plaquettes qui y sont empilées, est positionnée de sorte que lesdites surfaces principales sont en position verticale lorsque ladite cassette, avec lesdites plaquettes, est à l'extérieur de ladite chambre.

2. Système de traitement de semi-conducteurs selon la revendication 1, dans lequel ledit au moins un sas de chargement comprend en outre :
un moyen formant mécanisme de porte (30-40,50) pour ouvrir ladite porte de telle manière que ladite porte se déplace tout d'abord légèrement à l'écart de ladite ouverture puis s'abaisse parallèlement à ladite paroi latérale verticale de ladite chambre.

3. Système de traitement de semi-conducteurs selon la revendication 1 ou 2, dans lequel ledit au moins un sas de chargement comprend en outre :
un moyen formant pivot (14,15) pour faire pivoter ladite cassette avec lesdites plaquettes entre une première position dans laquelle ladite cassette avec lesdites plaquettes peut être abaissée par ledit moyen d'abaissement mécanique de cassette et une seconde position à partir de laquelle lesdites plaquettes deviennent accessibles à un équipement robotique (7) hors de ladite cassette et transportées en vue du traitement dans ladite au moins une chambre de traitement.

4. Procédé de chargement d'une cassette avec lesdites plaquettes dans le système de traitement de semi-conducteurs selon l'une quelconque des revendications 1 à 3, lequel procédé comprend les étapes consécutives suivantes :
a) le déplacement de ladite cassette avec lesdites plaquettes sur ladite structure support au travers de ladite ouverture selon un mouvement de pont-levis jusque dans ladite chambre de telle sorte que ladite cassette, avec les plaquettes qui y sont empilées, est positionnée de sorte que les surfaces principales desdites plaquettes sont en position verticale lorsque ladite cassette, avec lesdites plaquettes, est hors de la chambre, et ladite cassette, avec les plaquettes qui y sont empilées, est positionnée de sorte que lesdites surfaces principales sont en position horizontale lorsque ladite cassette, avec lesdites plaquettes, est dans ladite chambre ;
b) la fermeture de ladite porte pour fermer hermétiquement ladite ouverture ;
c) le pompage de l'atmosphère de ladite chambre pour y créer un vide ; et
d) le traitement desdites plaquettes dans ladite au moins une chambre de traitement.

5. Procédé selon la revendication 4, dans lequel l'étape b) comprend en outre :
- le déplacement de ladite porte vers le haut et parallèlement à ladite paroi latérale verticale de ladite chambre ; puis
- le déplacement de ladite porte étroitement contre ladite paroi verticale de ladite chambre pour fermer hermétiquement ladite ouverture.
